# EUROPEAN PATENT APPLICATION

(11) **EP 4 375 237 A1**
(43) Date of publication of application: **29.05.2024**
(21) Application number: 22845497.1
(22) Date of filing: 22.07.2022
(51) Int. Cl.: C01G 21/00, B82Y 40/00, H01L 31/0264

(54) **METHOD FOR PRODUCING METAL HALIDE PEROVSKITE NANOCRYSTAL LAYERS, NANOMETRIC-FILM NANOCOMPOSITE FORMED BY PEROVSKITE NANOCRYSTALS, METAL HALIDE PEROVSKITE NANOCRYSTAL LAYERS, AND USES OF SAID LAYERS**

(30) Priority: 23.07.2021 ES 202130716
(71) Applicant: Universitat de València, 46010 Valencia (ES)
(72) Inventor: NOGUERA GOMEZ, Jaume, 46010 Valencia (ES); ABARGUES LOPEZ, Rafael, 46010 Valencia (ES); PEREZ BOIX, Pablo, 46010 Valencia (ES)
(74) Representative: Torner, Juncosa I Associats, SL
(86) International application number: PCT/ES2022/070484
(87) International publication number: WO 2023/002086

(57) **Abstract**

The present invention provides a method for producing metal halide perovskite nanocrystal layers. The method comprises: preparing a first solution from an organic salt of a first multivalent metal in a first solvent; preparing a second solution comprising a halide of a monovalent cation, a halide of a second bi-, tri-or tetravalent metal, in a second solvent; mixing the first solution with the second solution; and depositing the mixture of the first and second solutions on a substrate. The first multivalent metal is a transition or alkaline earth element, and the second bivalent metal is tin and/or lead, or the trivalent metal is bismuth or antimony, or the tetravalent metal is tin. The invention also relates to a nanocomposite and to the uses of halide perovskite nanocrystal layers, particularly for photovoltaic applications, for optoelectronic applications, as sensors, etc.

## Description

### FIELD OF THE INVENTION

The present invention relates to a method for producing layers formed by metal halide perovskite nanoparticles, in particular embedded in organic-inorganic matrices. Likewise, the present invention relates to a nanocomposite in the shape of a nanometric film formed by perovskite nanocrystals, particularly of type ABX₃ or A₂BX₆, to metal halide perovskite nanocrystal layers, and to uses of said layers, in particular in photovoltaic and optoelectronic applications or as sensors.

### BACKGROUND OF THE INVENTION

There is currently a growing need for energy generation from renewable sources of energy in order to alleviate the serious effects of climate change. The most promising alternative is the use of photovoltaic solar energy, due to its great potential and the low cost to obtain it. For its widespread implementation, the development of technologies, such as photovoltaic cells capable of efficiently transforming energy in the form of electromagnetic radiation into electric energy, is essential. All this with the aim of reducing the dependence linked to the use of fossil fuels. Furthermore, the use of these semiconductive materials in applications within the field of optoelectronics, such as obtaining high-efficiency light-emitting diodes (LEDs), the use of lasers or photodetection, is of great interest if we also consider the possibility of their easy implementation in industrial manufacturing processes.

In the last decade, metal halide perovskite semiconductors have aroused growing interest in the scientific community, attracted by their remarkable optoelectronic properties, among which are high absorption coefficients, long diffusion lengths of the charge carrier, exceptional tolerance to defects, optical bandgap variation, and relatively high charge carrier mobility.

Unfortunately, perovskite structures in bulk form are limited with regard to the photoluminescence quantum yield (PLQY), and this occurs basically due to two factors: (i) the presence of defects of mobile ions characterized by low energy of formation, and (ii) low excitonic binding energy, resulting in low capture rates of electron-hole pairs for radiative recombination. On the other hand, the dominant intrinsic defects of the structure are very difficult to address. Furthermore, recent studies analyzing limits between particles corroborate that there are different values of photoluminescence intensity depending on position, the edges of the particles typically being the least emissive parts and presenting a rapid non-radiative decay. As a result of this, much of the research has centered its attention on perovskites in the form of nanocrystals, with the intention of not only enhancing the PLQY of conventional semiconductor materials, but also accessing applications derived from the quantum confinement associated with particle size.

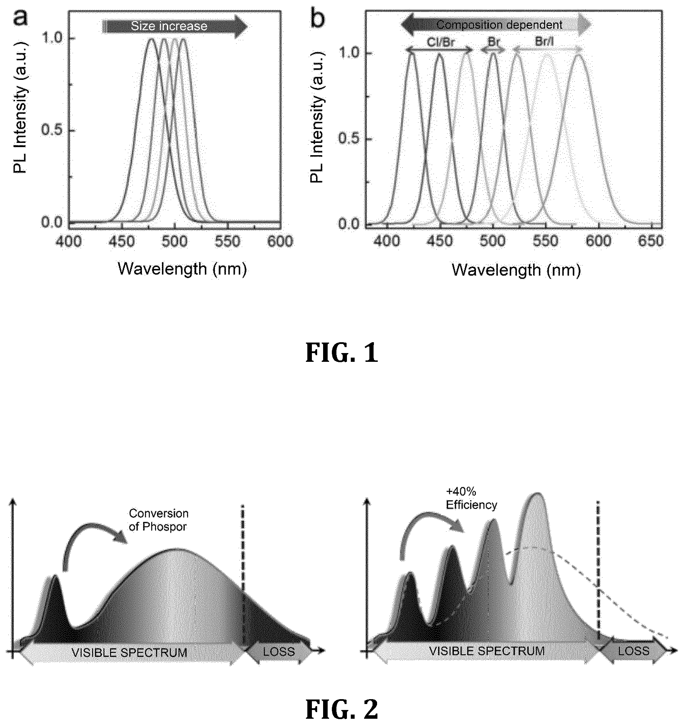

Unlike quantum dots of semiconductors of groups II/VI (CdS, CdSe, CdTe) or IV/VI (PbS, PbSe), perovskite nanoparticles offer much better optical properties in terms of emission quantum yield (close to 100%) because of their great tolerance to defects, as well as their great versatility when adjusting and varying their composition (through the halogen type), which allows for a highly effective tuning of their emission throughout the visible spectrum (FIG. 1).

This way, it is possible to control in a precise manner the light emission of the device by simply suitably combining perovskite nanocrystal of different composition and/or sizes. This allows for their application, for instance, in the spectral conversion of blue light into white light (down-converters). The resulting light can be tuned so that it will have a high color rendering index (i.e., more similar to natural light) and much more adjusted to the response range of the human eye, unlike current standards, such as phosphor-type converters (FIG. 2). This represents an improvement in energy efficiency since no IR light -to which the human eye is not sensitive- is emitted.

The most conventional method for the synthesis of mhPVK nanocrystals (NCs) is based on hot injection processes of the precursors. This method requires several steps and long preparation and purification times. Once synthesized, colloidal solutions are obtained that must be deposited for layers to form.

However, one of the main limitations of mhPVK NCs is due to their stability once synthesized in the form of a colloidal solution, since the NCs can become aggregated and precipitate, thus changing their optical properties. In turn, handling them outside inert environments produces degradation over time that is difficult to alleviate. Their limited chemical stability results in rapid degradation when exposed to humidity, light, and temperature under normal laboratory conditions.

It is mainly their instability as a colloidal solution and the difficulty in forming functional layers from said suspensions that limits their application in devices and which represents a bottleneck for their production. In this situation, approaches for the integration of these materials in organic-inorganic matrices emerge as a reliable alternative to combat their degradation. These matrices do not only provide good layer generation properties, but are also responsible for the *in-situ* and spontaneous generation of mhPVK in nanometric form without the need to incorporate ligands/stabilizers to be part of the structure of the material or any type of thermal or UV curing. In addition, the *in-situ* generation within these matrices allows controlling the size and dispersion of the particles inside the matrix, depending on the perovskite-matrix ratio. The choice of matrix is typically conditioned by the advantages one wishes to achieve in the final material, such as flexibility, hydrophobicity or as a protective barrier against their previously mentioned instability over time (mostly humidity).

The document "Nanoscale optical imaging of perovskite nanocrystals directly embedded in polymer fiber" discloses a method for synthesizing layers formed by fibers comprising metal halide perovskite nanoparticles (CsPbX₃ X = Cl, Br, and I) embedded in a polymer, formed from dilutions of their precursors at room temperature. The precursor dilution is deposited on a substrate using the single-stage electro-spinning technique. These layers have light emission properties (photoluminescence). By varying the composition of the precursor solution it is possible to control the optical properties of light emission.

Several scientific studies are known in the state of the art. For instance, the document "Recrystallization of CsPbBr₃ Nanoparticles in Fluoropolymer Nonwoven Mats for Down- and Up-Conversion of Light" describes a procedure similar to the one described in the previous document: a method for synthesizing layers, with light emission properties, formed by fibers comprising metal halide perovskite nanoparticles (CsPbX₃ X = Cl, Br, and I) embedded in a fluoropolymer, formed from dilutions of their precursors at room temperature. The precursor dilution is deposited on a substrate using the single-stage electro-spinning technique.

The document "Strongly luminescent and highly stable core-shell suprastructures from *in-situ* growth of CsPbBr₃ perovskite nanocrystals in multidentate copolymer micelles" discloses a method for synthesizing layers formed by copolymer micelles comprising metal halide perovskite nanoparticles (CsPbBr₃) embedded in a polymer, formed from dilutions of their precursors at room temperature.

The document "Water driven photoluminescence enhancement and recovery of CH₃NH₃PbBr₃/silicon oil/PDMS-urea composite" discloses a method for synthesizing light-emitting layers comprising metal halide perovskite nanoparticles (CH₃NH₃PbBr₃) embedded in a matrix formed by urea and PDMS, formed from dilutions of their precursors at room temperature.

The document "Novel CsPbX₃@mica composites with excellent optical properties far high efficiency and wide color gamut white light-emitting diode" discloses a method for synthesizing a composite, with photoluminescent properties, comprising metal halide perovskite nanoparticles (CsPbX₃(X = Cl, Br, I)) embedded in a mica matrix, from dilutions of their precursors at room temperature.

Finally, the document "High-Performance Planar Perovskite Solar Cells Using Low Temperature, Solution-Combustion-Based Nickel Oxide Hale Transporting Layer with Efficiency Exceeding 20%" discloses a method for preparing nickel oxide layers on perovskites, for the manufacture of solar cells.

There is therefore a need to have a methodology for the manufacture of thin films of NCs, with high emission efficiencies, stability of environmental conditions of humidity and temperature, good mechanical properties, low manufacturing cost on large area substrates that will allow for their application in photovoltaics (solar cells), optoelectronics (LEDs, lasers, and photodetectors) and sensing.

To that end, the present invention provides certain novelties in their preparation that have not been previously reported. On its own, integration within a matrix can be used as a simple, efficient way of improving the properties of perovskite-based materials.

### DISCLOSURE OF THE INVENTION

Exemplary embodiments of the present invention provide, according to a first aspect, a method for preparing metal halide perovskite nanocrystal layers comprising the following steps: preparing a first solution from an organic salt of a first multivalent metal in a first solvent; preparing a second solution comprising a halide of a monovalent cation, a halide of a second bi-, tri- or tetravalent metal, in a second solvent; mixing the first solution with the second solution; and depositing the mixture of the first and second solutions on a substrate.

Unlike the known proposals in the state of the art, in the present invention the first multivalent metal is a transition, alkaline or alkaline-earth element, and the second bivalent metal is tin and/or lead; if it is a trivalent metal, it is bismuth or antimony; and if it is a tetravalent metal, it is tin.

In an exemplary embodiment, the organic salt of a first multivalent metal is selected from the carboxylate group, consisting of acetate, formate, propionate, and/or mixtures thereof, preferably an acetate.

In an exemplary embodiment, the first bivalent metal is selected from the group consisting of magnesium, cobalt, zinc, antimony, tin, indium, nickel, and/or mixtures thereof, preferably nickel.

In an exemplary embodiment, the first solvent and/or the second solvent are selected from the group consisting of dimethylacetamide, dimethylformamide, methoxyethanol, and/or mixtures thereof, preferably dimethylformamide.

In an exemplary embodiment, the halide is selected from the group consisting of chloride, bromide, and iodide, and/or mixtures thereof, preferably bromide and iodide.

In an exemplary embodiment, the monovalent cation is selected from the group consisting of methylammonium, ethylammonium, formamidinium, cesium, and/or mixtures thereof, preferably methylammonium.

In an exemplary embodiment, the first solution is aged in a dry bath block, preferably between 5 and 30 minutes at a temperature between 50 and 90°C.

In an exemplary embodiment, the mixture of the first solution and the second solution satisfies a ratio in the range between 0.1:1 and 2:1 by volume, respectively.

In an exemplary embodiment, the concentration of the organic salt of the first bivalent metal in the first solvent is between 0.5 M and 3 M, and/or the concentration of the halide of the monovalent cation in the second solvent is between 0.5 M and 3 M, and/or the concentration of the halide of the second bivalent metal is between 0.5 M and 3 M.

In an exemplary embodiment, the deposition of the mixture on the substrate is carried out with a relative humidity between 15% and 100%, and at a temperature between 10°C and 200°C, preferably 25°C.

The deposition of the mixture on the substrate is carried out by means of different techniques, for instance, spin coating, doctor blade, slot-die coating, dip coating, inkjet printing, screen printing. In particular, spin coating is used.

In an exemplary embodiment, the spin coating is carried out between 500 and 8000 rpm, preferably 3000 rpm for a time between 10 seconds and 5 minutes.

The substrate can be transparent or opaque, rigid, semi-rigid, or flexible, and/or a natural plastic, *inter alia.* In a particular exemplary embodiment, the types of substrate comprise: ITO/FTO on glass, nickel sheets, aluminum, ITO/FTO on PET, PEN, PP, PE, polyamide, cellulose, etc.

In some exemplary embodiments, the present invention provides a method for obtaining layers of nanocomposites (or nanocompounds) of metal halide perovskite nanoparticles inside web-deposited organic-inorganic matrices for their use in photovoltaic and optoelectronic applications.

In some exemplary embodiments, the present invention provides a method of chemical synthesis and deposition of layers of nanocomposites formed by nanoparticles of metal halide perovskites (ABX₃ A being the monovalent cation methylammonium (MA), formamidinium (FA) or Cs; B being the divalent metal typically Pb y X = Cl, Br, I) embedded in organic-inorganic matrices. These layers are the basis for the development of photovoltaic devices, such as solar cells, as well as for their inclusion in LED-type emission optoelectronic devices, among some possible applications. Their formulation in the form of an ink further allows for their deposition on different substrates, both rigid and flexible. Combined with an easily scalable manufacturing method, the above favors their application in low-cost continuous roll-to-roll production techniques.

The most conventional method for the synthesis of metal halide perovskite (mhPVK) nanocrystals (NCs) is based on hot injection processes of the precursors for the formation of colloidal solutions. This method requires several steps and long preparation and purification times. Once synthesized, colloidal solutions are obtained that must be deposited for layers to form. One of the novelties of the invention lies in the *in-situ* synthesis of perovskite nanocrystals within a matrix once the latter has been deposited by spin coating, as well as other standard deposition or printing methods (slot-die coating, inkjet printing). Synthesis of mhPVK NCs occurs spontaneously at room temperature and in one single step. Counterintuitively, no thermal, ultraviolet or infrared curing is necessary. Once the nanocomposite has been deposited, the resulting layer has excellent light emission (photoluminescence) properties with quantum yields close to 100% and outstanding mechanical properties. Examples of matrices capable of incorporating perovskite nanocrystals include: metal (Ni, Co, K, Mg...) acetates subjected to a controlled aging process (sol-gel) and polymers (PEDOT/PSS, PVA...). A key aspect of this invention is that, for the formation of the nanocomposite, a specific molar ratio is necessary between the perovskite nanocrystal precursors and those of the matrix in order to control the final size of nanocrystals, their crystallinity and the separation therebetween and, thus, the optical properties of light emission.

Exemplary embodiments of the present invention further provide, according to a second aspect, metal halide perovskite nanocrystal layers obtained according to the method of the first aspect.

Likewise, exemplary embodiments of the present invention further provide, according to a third aspect, different uses of the metal halide perovskite nanocrystal layers of the second aspect in photovoltaic and optoelectronic applications or as sensors.

In yet another aspect, the present invention provides a nanocomposite in the form of a nanometric film formed by perovskite nanocrystals of type ABX₃ or A₂BX₆, the perovskites being embedded in a metal carboxylate matrix (Ni acetate).

With respect to the state of the art, the material in the form of composite of the present invention provides certain novelties in its preparation that have not been previously reported. On its own, integration within a matrix can be used as a simple, efficient way of improving the properties of perovskite-based materials.

This material and the way it is prepared represents an improvement in the state of the art because:
1. The precursor of the material is formulated as a solution or ink that is wet-deposited via fully industrially scalable deposition and printed methods. The precursor further allows a wide variety of possible formulations in order to adapt and meet rheological requirements, depending on the printing technique. This makes it possible to formulate it for compatibility with continuous roll-to-roll manufacturing techniques, as well as an ink in order to be deposited by inkjet type digital printing.
2. Once the precursor solution has been deposited, and in ambient temperature conditions (15-30°C) and controlled humidity (20 - 100%), spontaneous *in-situ* crystallization of the perovskite nanoparticles occurs without the need to complement the synthesis with a thermal treatment (neither UV nor IR). This fact is, by itself, a key step that enables deposition on any kind of (transparent and opaque) substrate, both rigid (e.g., ITO and FTO on glass), semi-rigid (thin sheets of nickel, aluminum...) and flexible (ITO and FTO on polyethylene terephthalate (PET), polyethylene naphthalene (PEN), polypropylene (PP), polyethylene (PE), polyimide (Kapton tape)) and even on natural plastic substrates (cellulose).
3. The conditions of the deposition and the subsequent treatment, including concentrations of the solution, solvents and precursors, (ambient) temperature of the solution and of the substrate, and humidity among others, define the characteristics and properties of the NC layers generated.
4. Under these preparation conditions, the nanocomposite shows excellent optical properties with photoluminescence quantum yields close to 100%, with high reproducibility.
5. Due to their formulation, the perovskite nanoparticles generated offer great versatility when it comes to adjusting and varying their composition and controlling their shape and size.

### BRIEF DESCRIPTION OF THE DRAWINGS

The above and other characteristics and advantages will be more fully understood from the following detailed description of exemplary embodiments by way of illustration and not limitation, with reference to the attached drawings, wherein:
FIG. 1: Change of photoluminescence with a) the nanocrystal size and b) composition.
FIG 2: Example of spectral conversions for applications in solid-state light conversion to replace current converters based on A₂O₃ phosphors doped with rare earths; i.e., A₂O₃ phosphors doped with rare earths (Eu³⁺, Tb³⁺, Tm³⁺).
FIG 3: Schematic illustration of the nanocomposite crystallization process. Influence of the humidity and concentration factors on the final properties after the crystallization of thin films.
FIG. 4: Cross sectional image of the perovskite nanocomposite.
FIG. 5: X-ray diffractogram of the X nanocomposite after its preparation under normal conditions.
FIG. 6: Comparison by ATR. In darker gray (left part of the image), the nickel acetate (NiAc₂) matrix; in lighter gray (right part of the image), the NiAc₂ - MAPbBr₃ nanocomposite.
FIG. 7A: Appearance of the nanocomposite layers at different perovskite (pvk) concentration ratios. FIG. 7B: Absorption spectra of the thin layers of Figure (A).
FIG. 8A: Appearance of the nanocomposite layers at different NiAc₂ matrix concentration ratios. FIG. 8B: PL spectra of the thin layers of Figure (A).
FIG. 9A: Appearance of the nanocomposite layers at different NiAc₂ matrix concentration ratios. FIG. 9B: Absorption spectra of the thin layers of Figure (A).
FIG.10A: Appearance of the nanocomposite layers at different NiAc₂ matrix concentration ratios. FIG. 10B: PL spectra of the thin layers of Figure (A).
FIG. 11: Study of the influence of humidity on the optical properties of the nanocomposite.
FIG. 12: Study of the influence of concentration and humidity on the photoluminescence of the nanocomposite layers vs. time.

### DETAILED DESCRIPTION OF EXEMPLARY EMBODIMENTS

Next, an example of operation of the invention based on obtaining thin films of the NiAc₂-MAPbBr₃ nanocomposite is described.

In this example, thin layers of "sol-gel" controlled aging procedure. To that end, nickel acetate tetrahydrate (Ni(CH₃COO)₂-4H₂O, 98% Alfa Aresas) is used as a matrix precursor and N,N-dimethylformamide (DMF) as a solvent. The typical matrix precursor formulation consists of a solution of NiAc₂ in DMF (10 mmol in 5 ml). The precursor solution was aged in a dry bath block for 10 min at 70°C.

During this process, as is typical of the sol-gel process, hydrolysis and condensation of the NiAc₂ in DMF occur, and colloidal clusters of NiAc₂ are generated as the viscosity of the solution increases. The precursor of the MAPbBr₃ NC was prepared by adding 10 mmol of methylamine bromide CH₃NH₃Br (MABr) and 10 mmol of lead (II) bromide (PbBr₂) in 5 ml of DMF solvent. Both NiAc₂ and MAPbBr₃ solutions were mixed in a specific ratio and deposited as ink by spin coating. After deposition, the different substrates were conveniently cleaned ultrasonically in a 1 M hydrochloric acid solution prepared from hydrochloric acid (HCl 35% by volume, VRW Chemicals) for 10 min and subsequently rinsed with a mixture of isopropanol (99.5% , VWR Chemicals) and acetone (99%, VRW Chemicals) in a ratio of 3:1. Thereafter, the samples were cleaned with deionized water (Millipore), dried with compressed air and, finally, an ozone treatment (for the removal of organic matter) is applied directly to the fastening side of the substrate for 10 min inside a UV chamber (Ossila Ozone Cleaner).

For the deposition of layers of the above-described NiAc₂-MAPbBr₃ solution, a volume of 100 µl is taken that is deposited on a substrate contacted by the spin-coating deposition technique at 3000 rpm for 30 seconds.

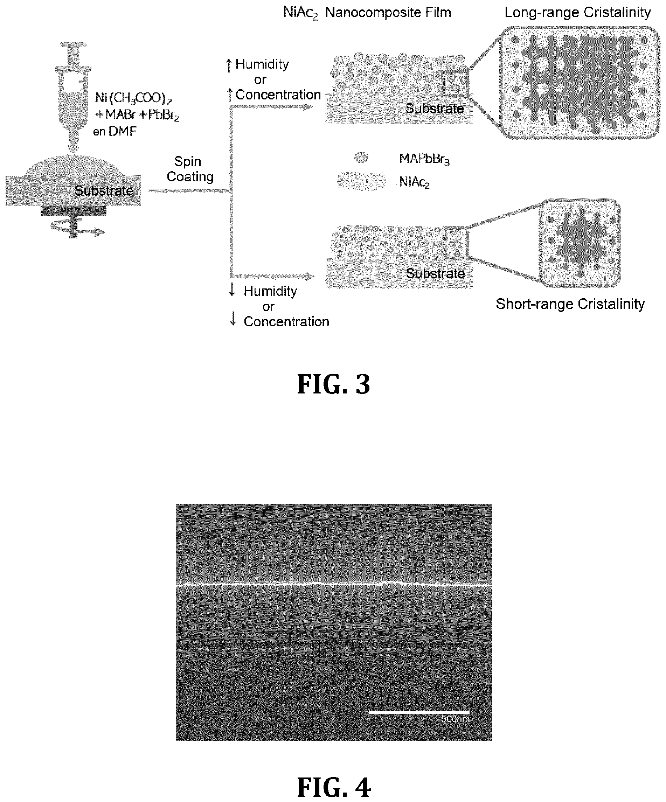

FIG. 3 illustratively shows the scheme of the nanocomposite generation process.

The morphology of the NiAc₂ - MAPbBr₃ nanocomposites was studied after their preparation by using a scanning electronic microscope (SEM). The result of said study revealed the presence of a highly compact amorphous thin film containing crystals therein in the form of metal halide perovskite nanoparticles.

### Structural characterization

X-Ray Diffraction (XRD): In turn, the layers were analyzed by X-ray diffraction so as to investigate the interaction or presence of MAPbBr₃ nanoparticles inside the NiAc₂ matrix. The resulting diffractograms are dominated by the presence of the most common peaks associated with the crystallographic planes of the cubic phase of MAPbBr₃ perovskite. In addition, through the Scherrer equation and with the diffractograms it has been possible to estimate that the size values of the nanoparticles is approximately 10 nm, which is in very good agreement with the values measured with transmission electronic microscopy (TEM).

ATR: Because with XRD the peaks associated with perovskite can be clearly identified and yet the role of the matrix is left unresolved, their presence was also studied by means of attenuated total reflection (ATR) in order to study the nanocomposite layers. The results allow us to corroborate the existence of the nickel matrix through the bonds typically associated with acetate (-COO-) and, in addition, with the appearance of a known band of the nitrogen-hydrogen bond located at 3200 cm⁻¹ (curve), the presence of the perovskite is reinforced, since this band would be associated with the N-H bond from the methylammonium cation (CH₃NH₃⁺).

### Optical characterization

After the structural characterization, the optical properties of the resulting nanocomposite were studied.

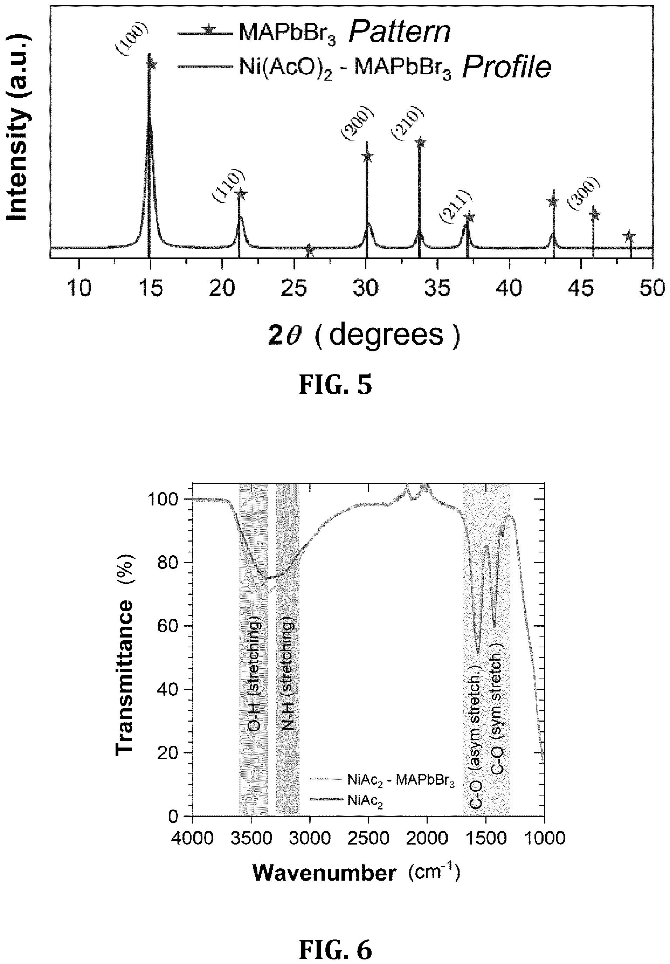

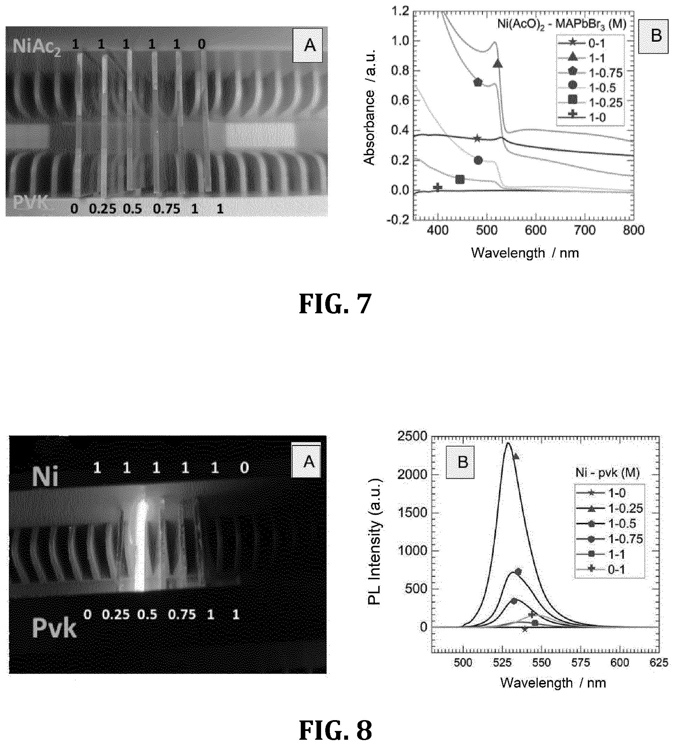

The study of optical properties focused primarily on the change in absorption and PL (photoluminescence) spectra and on the change in the nanocomposite formulation (ratio between MAPbBr₃ and NiAc₂). These results are shown in FIGs. 7A-7C. FIG.5B describes the absorption behavior of the thin layers after their deposition for different perovskite ratios. The trend shows the exciton generation characteristic of perovskite as its concentration increases.

In turn, photoluminescence (FIG. 8B) exhibits a similar behavior, but with one variation. At very high concentrations of perovskite, the emission shifts toward lower energies, its relative intensity being also lower. Likewise, as can be seen in FIG. 8A, the concentration 1-0.25 M is the one that allows the maximum intensity under normal conditions.

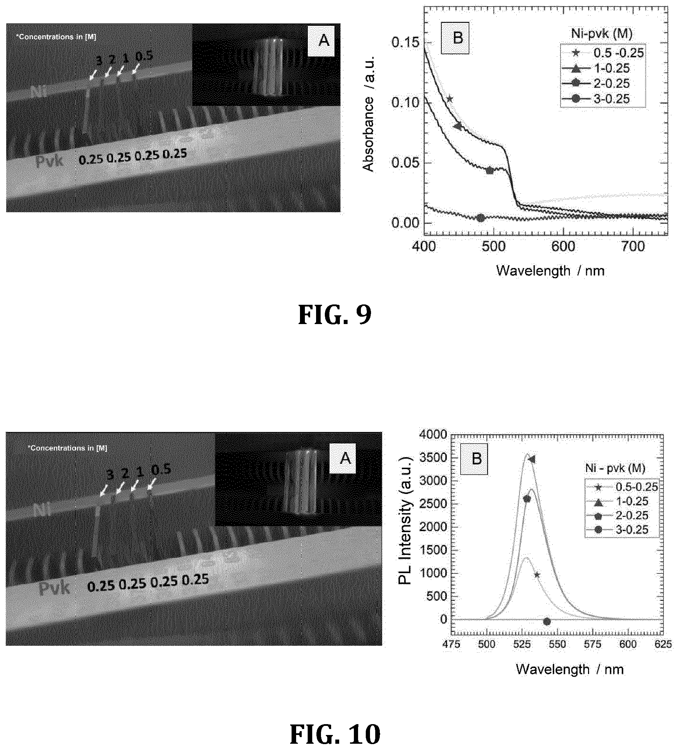

Similarly, the influence of the initial concentration of the nickel acetate matrix has been studied. The absorption and PL spectra are shown in FIGs. 9B and 10B, respectively.

With regard to absorption, the observed trend is an increase in the absorption peak characteristic of perovskite (centered at 540 nm), for a smaller matrix ratio or amount of perovskite.

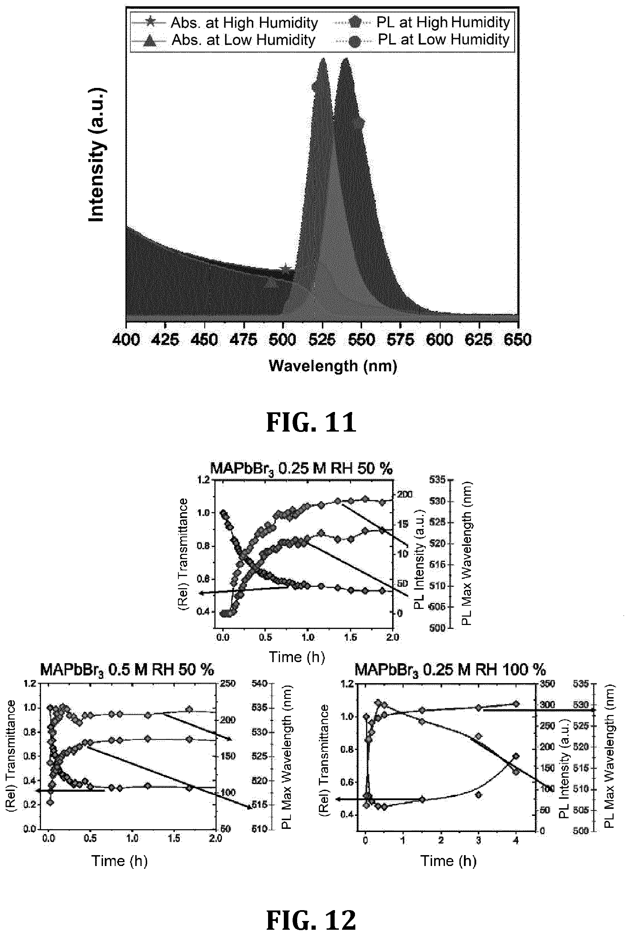

The PL spectra show a maximum for the same ratio as in the previous case (FIG. 8B). However, it was precisely in this case that it was observed that the times of nanoparticle generation varied with the increase in nickel acetate concentration. This leads one to think that the crystallization process is not solely controlled by spin coating, but is also mediated by the relative humidity of the environment. In this sense, in later experiences (FIG. 11) it has been possible to corroborate that the generation of nanoparticles and, as a result, their resulting size are conditioned by these factors.

With what has been described above, work was carried out to study the influence of relative humidity in the atmosphere. To that end, a specific ratio of NiAc₂ - MAPbBr₃ was studied at different concentrations of water in the air. This is achieved by working inside a sealed container wherein humidity is controlled and known. This way, FIG. 11 describes two different behaviors when working at a low relative humidity (RH) of about 50% or at a high RH of approximately 100%.

For low values of humidity (green curves) we have an emission shifted toward higher values of energy. If, on the other hand, after its preparation, this same sample is introduced for a given time into a container at high RH (blue curves), a shift toward a lower emission energy is observed signifying a change in the material. As verified by TEM, said change is related to the change in particle size; i.e., when the nanocomposite is exposed to a high presence of water in the atmosphere, crystallization occurs in a different way. This is indicative of greater aggregation of perovskite precursors, which results in larger final particle sizes. However, as described hereinbelow by studies, over time, a forced overexposure to high RH results in the total degradation of the thin layer, forcing the perovskite to break, reverting to its precursors (PbBr₂ and MABr), losing emission.

For such purposes, the influence of the change in emission and absorption of the thin layers at different concentration and under different RH over time has also been studied. The result of these tests is seen in FIG. 12.

The main advantage of the invention is the reduction in the cost of the technology for the generation of precursor layers in photovoltaic and optoelectronic devices with excellent optical properties (PLOY). The nanocomposite is generated in one single step after depositing a precursor solution of our matrix along with the perovskite precursors (as described in section 1.2 herein). This form of *in-situ* preparation, as opposed to classic synthesis methods such as hot injection, is a simpler alternative for the production of layers by scalable deposition processes such as spin coating, spray coating, dip coating or doctor blade, and also large-scale "roll-to-roll" printing, such as screen-printing, flexography, slot-die coating, and inkjet type digital printing.

The conditions of the deposition and the subsequent treatment, including concentrations of the solution, solvents and precursors, (ambient) temperature of the solution and of the substrate, and humidity, among others, allow to adjust the characteristics and properties of the NC layers, n determining the resulting optical, electronic and mechanical properties of the nanocomposite. This aspect confers great versatility to the process since they can be manipulated without compromising the optoelectronic quality of the layer. Furthermore, the precursor solutions have extensive stability over time, being capable of being stored for months without compromising the final properties of the composite layer.

In addition, their applications are not only limited to the field of optoelectronics and photovoltaics, but it has been seen that these materials are capable of varying their emission when exposed to gases of different elements, which generates great attraction in the field of materials for use as sensors.

The scope of the present invention is defined in the attached claims.

## Claims

1. A method for producing metal halide perovskite nanocrystal layers comprising the following steps:
- preparing a first solution from an organic salt of a first multivalent metal in a first solvent;
- preparing a second solution comprising a halide of a monovalent cation, a halide of a second bi-, tri- or tetravalent metal, in a second solvent;
- mixing the first solution with the second solution; and
- depositing the mixture of the first and second solutions on a substrate;
**characterized in that**:
the first multivalent metal is a transition, alkaline or alkaline-earth element, and the second bivalent metal is tin and/or lead, or the trivalent metal is bismuth or antimony, or the tetravalent metal is tin.

2. The method according to claim 1, wherein the organic salt of a first multivalent metal is selected from the group consisting of an acetate, formate, propionate, and/or mixtures thereof, preferably an acetate.

3. The method according to claim 1 or 2, wherein the first bivalent metal is selected from the group consisting of potassium, magnesium, cobalt, zinc, antimony, nickel, and/or mixtures thereof, preferably nickel.

4. The method according to any one of the previous claims, wherein the first solvent and/or the second solvent are selected from the group consisting of dimethylacetamide, dimethylformamide, methoxyethanol, and/or mixtures thereof, preferably dimethylformamide.

5. The method according to any one of the previous claims, wherein the halide is selected from the group consisting of chloride, bromide, and iodide, and/or mixtures thereof, preferably bromide and iodide.

6. The method according to any one of the previous claims, wherein the monovalent cation is selected from the group consisting of methylammonium, ethylammonium, formamidinium, cesium, and/or mixtures thereof, preferably methylammonium.

7. The method according to any one of the previous claims, wherein the first solution is aged in a dry bath block, preferably between 5 and 30 minutes at a temperature between 50 and 90°C.

8. The method according to any one of the previous claims, wherein the mixture of the first solution and the second solution satisfies a ratio in the range between 0.1:1 and 2:1 by volume, respectively.

9. The method according to any one of the previous claims, wherein the concentration of the organic salt of the first bivalent metal in the first solvent is between 0.5 M and 3 M, and/or the concentration of the halide of the monovalent cation in the second solvent is between 0.5 M and 3 M, and/or the concentration of the halide of the second bivalent metal is between 0.5 M and 3 M.

10. The method according to any one of the previous claims, wherein the deposition of the mixture on the substrate is carried out with a relative humidity between 15% and 100%, and at a temperature between 10°C and 200°C, preferably 25°C.

11. The method according to any one of the previous claims, wherein the deposition of the mixture on the substrate is carried out by spin coating, doctor blade, slot-die coating, dip coating, inkjet printing, preferably spin coating.

12. The method according to claim 11, wherein the spin coating is carried out between 500 and 8000 rpm, preferably 3000 rpm for a time between 10 seconds and 5 minutes.

13. The method according to any one of the previous claims, wherein the substrate is transparent or opaque, rigid, semi-rigid, or flexible, and/or a natural plastic.

14. A nanocomposite in the shape of a nanometric film formed by perovskite nanocrystals of type ABX₃ or A₂BX₆, A being the monovalent cation methylammonium (MA), formamidinium (FA) or Cs; B being the divalent metal, typically Pb y X = Cl, Br, I, **characterized in that** the perovskites are embedded in a metal carboxylate matrix.

15. Metal halide perovskite nanocrystal layers obtained according to the method defined in any one of claims 1 to 13.

16. Use of the metal halide perovskite nanocrystal layers according to claim 14 in photovoltaic and optoelectronic applications or as sensors.
